# EUROPEAN PATENT SPECIFICATION

(11) **EP 3 923 424 B1**
(45) Date of publication and mention of the grant of the patent: **24.07.2024**
(21) Application number: 20178973.2
(22) Date of filing: 09.06.2020
(51) Int. Cl.: H01S 5/02, H01S 5/022, H01S 5/042, H01S 5/10, H01S 5/02326, H01S 5/024

(54) **METHOD FOR PROCESSING A LASER DEVICE**
VERFAHREN ZUR VERARBEITUNG EINER LASER-VORRICHTUNG
PROCÉDÉ DE TRAITEMENT D'UN DISPOSITIF LASER

(43) Date of publication of application: 15.12.2021
(73) Proprietor: Imec VZW, 3001 Leuven (BE)
(72) Inventor: Caer, Charles, 3001 Leuven (BE); Soussan, Philippe, 3001 Leuven (BE); Sabuncuogly Teczan, Deniz, 3001 Leuven (BE); Karve, Gauri, 3001 Leuven (BE); Li, Yunlong, 3001 Leuven (BE)
(74) Representative: Roth, Sebastian

(56) References cited:
- US-A1- 2015 097 210
- US-A1- 2015 123 157
- US-A1- 2017 207 600
- US-A1- 2018 183 212

## Description

### TECHNICAL FIELD OF THE INVENTION

The present disclosure relates to a method for processing a laser device and to a laser device, in particular a III-V on silicon laser co-integrated with photonics devices, such as waveguides.

### BACKGROUND OF THE INVENTION

The term silicon photonics refers to photonic systems and circuits based on silicon, for instance, silicon-based chips for optical data transmission. Since silicon is not well suited for light emission, it is desirable to integrate light emitting dies made of other more suitable semiconductor materials, especially III-V materials, on silicon substrates. A laser device with a III-V die on a silicon substrate is referred to as a III-V on silicon laser.

However, the integration of such a III-V die on the silicon substrate is difficult and one of the key challenges of silicon photonics. Existing solutions are either relying on external III-V die assembly such as flip-chip bonding, III-V on silicon hetero-epitaxy or heterogeneous wafer/die bonding. However, each of these approaches has its own drawbacks.

External III-V die assembly is the easiest solution and is commercially available. It, however, suffers from low alignment tolerances associated with high packaging costs, coupling losses and unwanted back-reflections in the III-V die.

III-V on silicon heteroepitaxy is still mostly at research level. The main drawback resides in the need of growing very thick buffer layers in specific areas to filter dislocations. The thick layers, however, may prevent coupling to silicon photonic devices. Currently this approach also does not allow a large light output.

Heterogeneous integration of III-V wafers/dies is another approach that allows a III-V layer transfer to silicon. The main drawbacks are the thermal isolation of the III-V from the silicon substrate by oxides, degrading laser performance and reliability, and limited throughput caused by the pick and place process used for fabrication that requires a high alignment accuracy with the underlying photonic devices.

US 2015123157 A1 discloses a method of fabricating a composite semiconductor structure including providing an SOI substrate including a plurality of silicon-based devices, providing a compound semiconductor substrate including a plurality of photonic devices, and dicing the compound semiconductor substrate to provide a plurality of photonic dies.

US 2017207600 A1 discloses methods for realizing integrated lasers and photonic integrated circuits on complimentary metal-oxide semiconductor (CMOS)-compatible silicon (Si) photonic chips, potentially containing integrated electronics.

### SUMMARY OF THE INVENTION

Thus, it is an objective to provide an improved method for processing a laser device, and to provide an improved laser device, in particular a III-V on silicon laser. In particular, the above-mentioned disadvantages should be avoided.

The objective is achieved by the embodiments provided in the enclosed independent claims. Advantageous implementations of the embodiments of the invention are further defined in the dependent claims.

According to a first aspect, the present disclosure relates to a method for processing a laser device, in particular a III-V on silicon laser, comprising:
- providing a carrier substrate;
- forming a grating structure on the carrier substrate, wherein the grating structure delimits a cavity on a surface of the carrier substrate;
- placing a die in the cavity and bonding the die to the carrier substrate, wherein the die comprises an active region from at least one III-V semiconductor material;
- transferring the die from the carrier substrate to a silicon substrate by bonding an exposed side of the die to the silicon substrate and subsequently debonding the carrier substrate from the die;
- forming at least one material layer on the die so that the die is fully covered; and
- forming a photonic structure, preferably a structure formed from a material with high refractive index, such as a silicon waveguide, above the die.

This achieves the advantage that a III-V on silicon laser can be processed efficiently and with high accuracy. In particular, no placing of individual III-V dies and active alignment of their laser output regions on the silicon substrate is required, which simplifies the processing of the laser device and allows for a high throughput.

Preferably, the gain region and the photonics structure are directly aligned by a high accuracy lithographic process.

The active region can comprise a plurality of different materials, in particular arranged as a heterostructure. For example, the active region of the die comprises an indium gallium aluminum arsenide (InGaAlAs), an indium gallium nitride (InGaN) and/or an indium arsenide (InAs) material. The active region can comprise quantum dots and/or multiple quantum wells (MQWs). Other III-V and III-N substrates can be comprised in the active region, e.g. gallium nitride (GaN), gallium arsenide (GaAs), or gallium antimonide (GaSb).

Preferably, the die is bonded to the carrier substrate with the active region pointing towards the carrier substrate, and a die-substrate pointing upwards and away from the carrier substrate.

The carrier substrate can be a silicon or a glass substrate. Preferably, the carrier substrate is a wafer.

The at least one material layer can comprise a silicon dioxide (SiO₂) layer and/or a silicon nitride (Si₃N₄) layer.

The photonic structure can be a waveguide. Alternatively, the photonic structure can be a photonic crystal, a quantum wire, a quantum dot, or any other structure suitable for confining light.

In an embodiment, the photonic structure is made of a high refractive index material, such as silicon or silicon nitride (Si₃N₄). In particular, the material of the photonic structure has a higher refractive index than materials directly surrounding the photonic structure, such that light can efficiently be confined and/or guided in the photonic structure.

The photonic structure can be arranged above the active region such that light that is generated in the active region couples to the photonic structure, in particular by means of evanescent coupling.

In an embodiment, the grating structure on the carrier substrate is formed by bonding a structured substrate to the surface of the carrier substrate, wherein the structured substrate comprises a through hole.

This achieves the advantage that the grating structure can be formed in an efficient way.

The structured substrate can be a structured silicon wafer covered by an SiO₂ layer. After bonding the structured substrate to the carrier substrate, the through hole of the structured substrate can form the cavity for the die.

In an embodiment, after placing the die in the cavity, the cavity is at least partially filled up by a buffer material, in particular an oxide.

This achieves the advantage that gaps in the cavities, in particular between the dies and the cavity walls, can be prevented. In particular, filling any gaps in the cavity allows processing the substrate in later steps, for instance grinding the die and grating structure.

The buffer can be formed by a spin-on-glass process and can be annealed in a subsequent step to form SiO₂.

In an embodiment, the grating structure is transferred together with the die from the carrier substrate to the silicon substrate.

This achieves the advantage that the die can be transferred efficiently by a single bonding/debonding process. In particular, if the grating structure forms several cavities on the carrier substrate, wherein a respective die is arranged in each cavities, then these multiple dies can be transferred simultaneously together with the grating structure without needing to individually pick-and-place and align each die on the silicon substrate.

In an embodiment, prior to transferring the die and the grating structure to the silicon substrate, the die and the grating structure are grinded and/or polished.

This achieves the advantage that an interface for bonding the dies and grating structure to the silicon substrate can be formed. Furthermore, the thinning of the dies that are subsequently bonded to the silicon substrate enhances heat dissipation from the active region and, therefore, reliability.

The die and/or grating structure can be polished by means of chemical-mechanical polishing (CMP).

In an embodiment, the die comprises a top structure and a base structure that delimit the active region, wherein the top and base structure each comprise at least one III-V or III-N material layer, in particular an indium phosphide (InP), a gallium nitride (GaN), a gallium arsenide (GaAs), an indium arsenide (InAs) or a gallium antimonide (GaSb) layer, wherein the base structure is bonded to the silicon substrate, preferably via at least one bonding layer.

The base structure of the die comprises a die-substrate on which the active region is arranged, and which is bonded to the silicon substrate.

In an embodiment, the method further comprises:
- following transferring the die to the silicon substrate, structuring the die by a lithographic process to define a dimension of the active region and/or to expose the base structure of the die.

This achieves the advantage that a precise alignment of the die, in particular the active region, can be realized. In this way, misalignments of the die that result from inaccuracies when placing the die in the cavity can be compensated.

Defining a dimension of the active region may comprise reducing its overall size and centering the active region, so that the exact position and size of the active region on the silicon substrate is defined for later processing steps. In particular, the lithographic process can be carried out by an advanced lithographic tool, such as a 193 nm DUV stepper. Thus, no active alignment of individual dies on the silicon substrate needs to be carried out.

In an embodiment, the method further comprises the steps of:
- forming contact pads on the top structure and the exposed base structure of the die; and
- following forming of the at least one material layer above the die, electrically contacting the contact pads by etching vias into the at least one material layer and filling said vias with a metal.

This achieves the advantage that an electrical contact active region can be generated efficiently.

Preferably, the contact pads are formed from a CMOS compatible material. The contact pads can form Ohmic contacts on the die.

In an embodiment, the photonic structure is a silicon waveguide.

In an embodiment, the photonic structure is formed by depositing a further material layer, in particular a silicon layer, above the die and lithographic structuring said further material layer.

This achieves the advantage that the photonic structure can be generated efficiently and with high alignment accuracy to the active region of the die. For example, the further material layer is a silicon layer.

In an embodiment, a further photonic structure, preferably a silicon nitride waveguide, is formed above the die, wherein the further photonic structure is arranged above or next to the photonic structure.

This achieves the advantage that a photonic structure can be provided for forwarding the light generated by the III-V, for instance to a photonic circuit.

The further photonic structure can be formed from LPCVD silicon nitride that can, for instance, be applied by wafer bonding. The further photonic structure can alternatively be formed from a low loss material, such as niobium oxide or tantalum pentoxide.

In an embodiment, the method comprises the further steps of:
- forming a recess at a backside of the silicon substrate below the die; and
- coating the backside of the silicon substrate with a metallic material.

This achieves the advantage that a heat dissipating structure can be formed on the backside of the silicon substrate, for dissipating heat away from the III-V die.

Preferably, prior to forming the recess, the silicon substrate is thinned down from the backside. This supports dissipating heat away from the active region.

In an embodiment, the grating structure delimits a plurality of cavities on the surface of the carrier substrate, wherein one of a plurality of dies is placed in each respective cavity and bonded to the carrier substrate, wherein the plurality of dies are transferred from the carrier substrate to the silicon substrate simultaneously.

In this way, the process allows forming a plurality of laser devices or a laser device with a plurality of dies simultaneously. The dies and the grating structures can be transferred simultaneously from the carrier substrate to the silicon substrate. The at least one material layer can be formed above the dies, so that all dies are fully covered. Further, a respective photonic structure, e.g. a waveguide, can be formed above each die.

A laser device processed with the method of the first aspect shows clear "fingerprints" of that method. By placing the die in a cavity on a carrier substrate, transferring the dies to a silicon wafer, preferably together with the grating structure which forms the cavity, and coating the transferred die with at least one material layer, the die is fully embedded on the silicon substrate. In particular, the die is fully covered by the material layer and no area of the die is exposed.

According to a second aspect, the present disclosure relates to a laser device, obtained by the method of the first aspect, in particular a III-V on silicon laser, comprising: a silicon substrate, a die that is arranged in a cavity on the silicon substrate, wherein the die comprises an active region from at least one III-V semiconductor material, wherein the die is bonded to the silicon substrate, wherein the die is fully covered by at least one material layer, wherein the die comprises a top structure and a base structure which comprises a die-substrate, said top structure and said base structure delimiting the active region, wherein the top structure and the base structure each comprise at least one III-V or III-N material layer, wherein the base structure is bonded to the silicon substrate, wherein the active region of the die faces away from the silicon substrate and forms a III-V mesa over the die-substrate, and wherein the laser device further comprises at least one photonic structure, preferably a silicon waveguide and/or a silicon nitride waveguide, that is arranged above the die in a direction away from the silicon substrate.

This achieves the advantage that a III-V laser on a silicon substrate can be provided.

In particular, the III-V active region is fully embedded such that the laser device can be further processed, e.g. by lithographic processing.

In an embodiment, the top and base structure each comprise at least one III-V or III-N indium phosphide (InP), gallium nitride (GaN), gallium arsenide (GaAs), indium arsenide (InAs) or gallium antimonide (GaSb) layer, wherein the base structure is bonded to the silicon substrate via at least one bonding layer.

This achieves the advantage that gaps in the cavities, in particular between the dies and the cavity walls, can be prevented.

In an embodiment, the laser device comprises a plurality of dies, wherein each of the plurality of dies is arranged in a respective cavity on the silicon substrate.

The above description with regard to the method for processing the laser device according to the first aspect of the present disclosure is correspondingly valid for the laser device according to the second aspect of the present disclosure.

### BRIEF DESCRIPTION OF THE DRAWINGS

The invention will be explained in the followings together with the figures.
- Figs. 1a-l: show steps of a method for processing a laser device according to an embodiment;
- Fig. 2: shows a cross sectional view of a laser device according to an embodiment;
- Figs. 3a-d: shows schematic diagrams of several dies suitable for the laser device of Fig. 2 according to further embodiments; and
- Fig. 4: shows a three dimensional and a cross sectional view of a laser device according to an embodiment.

### DETAILED DESCRIPTION OF THE PREFERRED EMBODIMENTS

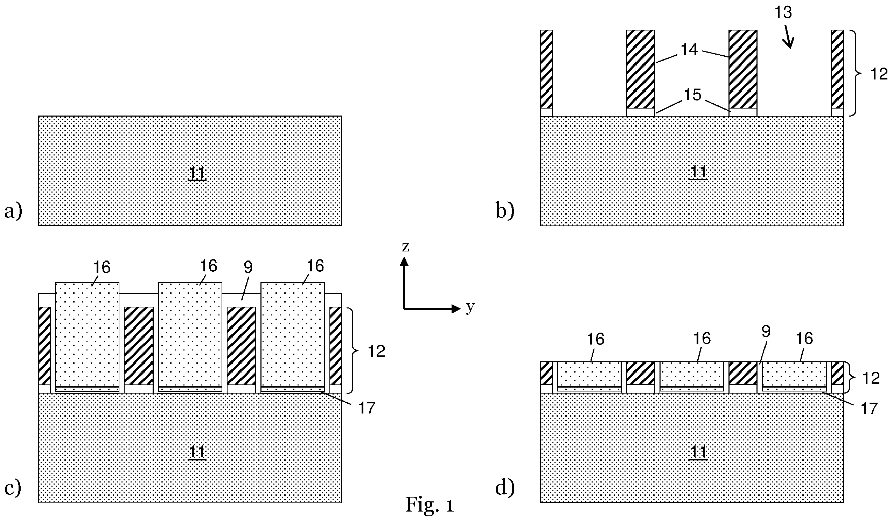

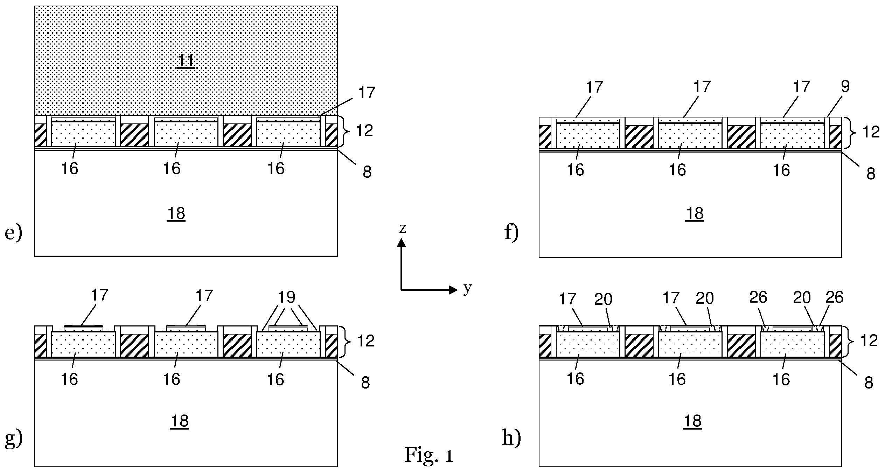

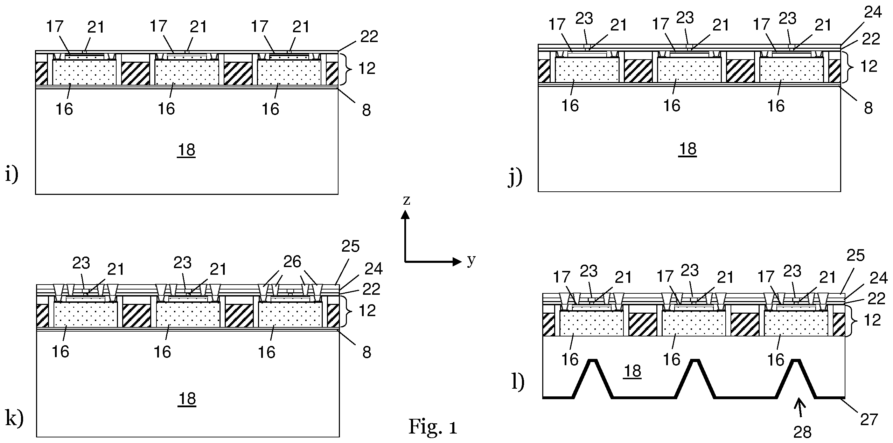

Figs. 1a-l show steps of a method for processing a laser device, in particular a III-V on silicon laser, according to an embodiment corresponding to the invention as defined in claim 1 and dependent claims.

The method can be used to process a plurality of laser devices in parallel, each laser device comprising one or more dies 16 with III-V active regions. For instance, Figs. 1a-l either show a processing of three laser devices each having one die 16, or of a single laser device having three or more dies 16. For the sake of clarity, in the following the method is explained with reference to a laser devices having one die, the same method steps apply to all other laser devices and/or to further dies/photonic structures of the laser device.

The method comprises, as shown in FIG. 1a, providing a carrier substrate 11. The carrier substrate 11 can be a glass or a silicon wafer. In particular, the substrate 11 is a temporary carrier wafer.

As shown in Fig. 1b, the method comprises forming a grating structure 12 on the carrier substrate 11, wherein the grating structure 12 delimits a cavity 13 on the surface of the carrier substrate 11.

The grating structure 12 can be formed by bonding a structured substrate to the surface of the carrier substrate 11. The structured substrate can comprise a silicon or InP base structure 14 that is covered by an oxide layer 15. The structured substrate can be bonded to the carrier substrate 11 via the oxide layer 15. Further, the structured substrate can comprise at least one through hole, which forms the cavity 13 on the carrier substrate 11. In particular, the structured substrate can be a silicon or InP wafer that is oxidized, etched and thinned down to form open cavities on the carrier substrate 11.

The oxide layer 15 of the structured substrate can have a thickness of several microns.

The structured substrate can be grinded after bonding it to the carrier substrate 11.

As shown in Fig 1c, a die 16 can be placed in the cavity 13 and bonded to the carrier substrate 11. Thereby, the active region 17 of the die 16 is facing down, towards the carrier substrate 11. In other words, the cavity 13 defines a pocket that can be populated with the III-V die 16.

The die 16 can comprises a top and a base structure that delimit the active region 17, wherein the top structure is bonded to the carrier substrate 11, such that the base structure faces up and away from the carrier substrate 11. Preferably, the base structure of the die 16 comprises a die-substrate on which the active region 17 is arranged.

In a subsequent step, also shown in Fig. 1c, the cavity 13 can be filled up by a buffer material 9, in particular by a spin-on-glass, that is cured, respectively annealed, to form an oxide.

Subsequently, as shown in Fig. 1d, the die 16 and the grating structure 12 can be thinned down by grinding and/or polishing, in particular by means of chemical mechanical polishing (CMP), in order to generate a surface that is suitable for the following bonding step. For example, the die 16 and grating structure 12 are thinned down to a few microns. In particular, the III-V die 17 and silicon planarization enables heterogeneous III-V material integration.

As shown in Fig. 1e, the method further comprises bonding the thinned die and grating structure to a silicon substrate 18, preferably via a bonding layer. The bonding layer can be a SiO₂ layer.

In a subsequent step, shown in Fig. 1f, the carrier substrate 11 is debonded from the die 16 and grating structure 12. Consequently, the die 16 on the silicon substrate 18 is arranged in such a way that the active region 17 is facing up and away from the silicon substrate 18. The die 16 is bonded to the silicon substrate 18 by its base structure.

In a subsequent step, shown in Fig. 19, the die 16 can be structured by a lithographic process to define a dimension and exact position of the active region 17 and/or to expose the base structure of the die 17. According to the invention as defined in claim 14, the active region 17 of the die 16 forms a III-V mesa.

Preferably, the lithographic structuring of the active region 17 is carried out by a high accuracy scanner or stepper, e.g., a 193 nm DUV stepper or another advanced CMOS fab tool. This allows for a precise definition of the III-V MESA structure of the lasers (active region 17) and the respective positioning of the waveguide 21, 23 to the mesa with <100 nm precision (see Figs. 1i-k). In particular, when fabricating several laser devices in parallel, this lithographic structuring allows a precise alignment of the active regions 17 of all dies 16 on the silicon substrate 18 in a single step. Thereby, thick active layers (>10 µm), which are essential for high power lasers can be structured to accurately align the laser output region to a photonic circuit.

Preferably, the method further comprises forming contact pads 19 on the top structure and the exposed base structure of the die 16. The contact pads 19 can be formed from a CMOS compatible material, e.g. a CMOS compatible metal.

In a subsequent step, shown in Fig. 1h, an oxide layer 20 can be formed on and around the structured die 16. Subsequently, the contact pads 19 are electrically contacted by etching vias 26 in the oxide layer 20 and filling the vias 26 with a metallic material, e.g. tungsten (W). The oxide layer 20 can further be planarized to allow deposition further layers on top.

Subsequently, as shown in Fig. 1i, a photonic structure 21 can be formed above the die 16. The photonic structure 21 can be formed by depositing a subsequently lithographic structuring of a material layer, e.g. an amorphous silicon (a-Si) layer.

The photonic structure 21 can be a waveguide, in particular a silicon waveguide. For example, the waveguide extends along an x-direction, perpendicular to the cross sectional view of the silicon substrate 18 and die 16 in y-z-direction as indicated by the schematic coordinate system.

The method can further comprise a deposition of an oxide layer 22 around the waveguide 21 and a planarization of the waveguide 21 and the oxide layer 22.

As shown in Fig. 1k, the method can further comprise forming a further photonic structure, e.g., a further waveguide 23, above the die 16. The further photonic structure can be made of silicon nitride (Si₃N₄) and can be formed by lithographic structuring a silicon nitride layer. The silicon nitride layer can be deposited on the oxide layer 22, e.g. using a Plasma-Enhanced Chemical Vapor Deposition (PECVD) or a Physical Vapor Deposition (PVD) process. Alternatively, the silicon nitride layer can be transferred from a further substrate that is bonded and, subsequently, debonded to respectively from the oxide layer 22.

Following the formation of the further photonic structure, a further oxide layer 24 can be formed around the further waveguide 23 and a planarization of the further waveguide 23 and the further oxide layer 24 can be performed.

Subsequently, as shown in Fig. 1k, another oxide layer 25 can be deposited on the further oxide layer 24. Finally, vias 26 can be etched in the oxide layer 25 and filled with a metallic material, to electrically contact the contact pads 19.

In particular, the silicon photonics layers 22, 24 and structures 21, 23 are built above the III-V active region 17, enabling high alignment accuracy and high device quality, e.g., on a 200 or 300 mm wafer scale.

In a further step, shown in Fig. 1l, the silicon substrate 18 can be thinned and a recess 28 can be formed on the silicon substrate 18 backside below the die 16. The recess 28 can be etched via isotropic etching, e.g., wet etching with potassium hydroxide (KOH), and can form a cavity on the substrate 18 backside. In addition, a metal coating 27, e.g. a copper coating, can be deposited on the backside of the silicon substrate 18. The coated cavity on the backside of the silicon substrate can form a heat spreading structure that supports dissipating heat away from the die 16 and the active region 17.

In particular, the wafer reconstitution method shown in Figs. 1a-l enables the realization of hybrid devices through the coupling between the III-V active regions 17 and the photonic layers and structures, e.g. structures 21, 23.

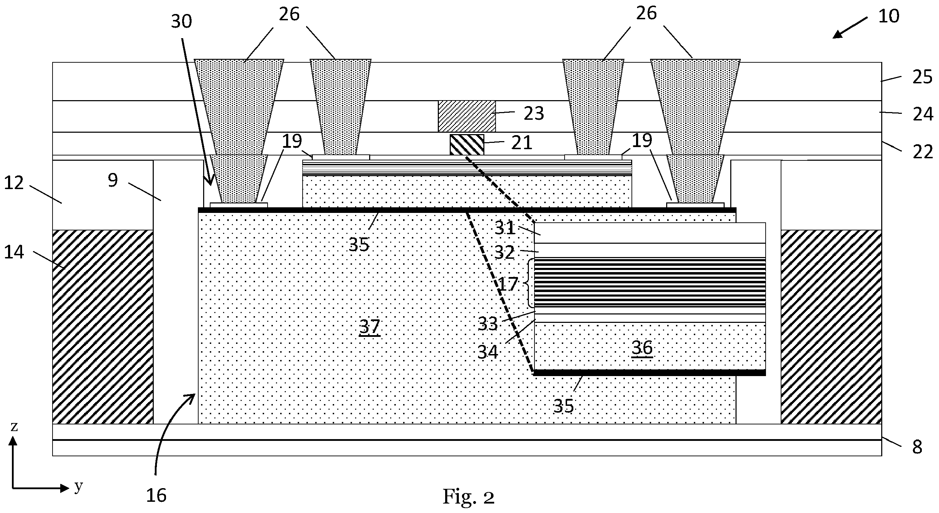

Figs. 2 shows a cross sectional view of a laser device 10 according to an embodiment.

In particular, the laser device 10 shown in Fig. 2 was processed by the method depicted in Figs. 1a-l. Preferably, the laser device 10 is a III-V on silicon laser.

The laser device 10 comprises the silicon substrate (not shown) and the die 16 that is arranged in a cavity 30 on the silicon substrate, wherein the die 16 comprises the active region 17 from at least one III-V semiconductor material. The die 16 is bonded to the silicon substrate, preferably by means of at least one bonding layer 8, and is fully covered by at least one material layer 22, 24, 25. The laser device 10 further comprises at least one photonic structure 21, 23, preferably a silicon waveguide and/or a silicon nitride waveguide that is arranged above the die 16.

In particular, the cavity 30 on the silicon substrate corresponds to the cavity 13 that is formed on the carrier substrate 11 and transferred to the silicon substrate 18 together with the grating structure 12 and the die 16 during processing of the laser device 10 according to Figs. 1a-l.

According to the invention as defined in the claim 14, the die 16 comprises a top structure and base structure that delimit the active region 17. The top structure can comprise a top layer 31, e.g. a InP layer, that is electrically contacted via the contact pad 19 and a SCH layer 32 that is adjacent to the active region 17.

The base structure can be bonded to the silicon substrate via the bonding layer 8. The base structure can comprise a plurality of different layers 33-36, for instance, a further SCH layer that is adjacent to a bottom side of the active region 17 and EBL layers 34, 35. The base structure further comprises a die-substrate 37 on which the active region 17 and the layers 33-36 are arranged, and which is bonded to the silicon wafer. The contact pads 19 on the backside of the active region 17 can be arranged on the bottom EBL layer 35.

Top and base structures can comprise III-V or III-N material layers, in particular indium phosphide (InP), gallium nitride (GaN), gallium arsenide (GaAs), indium arsenide (InAs) or gallium antimonide (GaSb) layers. The active region 17 can comprise a III-V stack and/or heterostructure.

The cavity 30 can be formed by the grating structure 12 on the silicon substrate, and can be filled up by the buffer material 9. In particular, the die 16 can be higher than the structured substrate forming the cavity, such that the die protrudes out of the cavity.

This achieves the advantage that gaps in the cavities, in particular between the dies and the cavity walls, can be prevented.

In an embodiment, the laser device 10 comprises a plurality of dies 16, wherein each of the plurality of dies 16 is arranged in a respective cavity 30 on the silicon substrate.

For example, the die 16 can have a width in y-direction of ca. 20 µm. The photonic structures 21, 23 above the die 16 can have a height of ca. 1 µm and the material layers 22, 24, 25 can have a total height of 6-10 µm. The total thickness of the laser device 10 in z-direction can be ca. 400 µm (including the silicon substrate that is not shown in Fig. 2). These design parameters are just example values, other design parameters can be chosen depending on the requirements and materials.

In particular, the laser device 10 is suitable for integration in various electronic devices, such as tunable III-V on silicon lasers, electro-optic linear modulators, waveguide coupled III-V detectors, high power (>100 MW) sources for sensors, optoelectronic transceivers, spectrometers, or Light Detection and Ranging (LidAR) scanners.

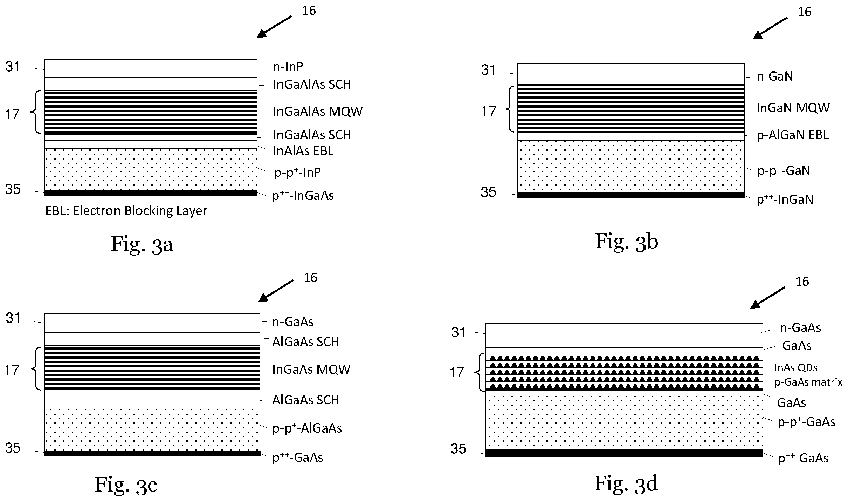

Figs. 3a-d show schematic diagrams of several dies 16 suitable for the laser device 10 of Fig. 2 according to further embodiments. In particular, Figs. 3a-d each show an upper section of a die 16 that was structured by a lithographic process, as shown in Fig. 19.

Fig. 3a shows a die with an active region 17 comprising indium gallium aluminum arsenide (InGaAlAs) multiple-quantum-wells (MQW). This active region 17 is, for example, adapted to emit light in the near or mid infrared range, e.g. at 1.550 nm. The die comprises an InP top layer 31.

Fig. 3b shows a die 16 with a gallium nitride (GaN) laser profile, with an active region comprising gallium nitride (InGaN) MQWs. The top layer 31 of the die 16 in Fig. 3b is made of GaN.

Fig. 3c shows a die 16 with a gallium arsenide (GaAs) laser profile, wherein the active region comprises indium gallium arsenide (InGaAs) MQWs.

Fig. 3d shows a die 16 with an InAs quantum dot (QD) laser profile, wherein the active region 17 comprises indium arsenide (InAs) QDs arranged in a p-doted gallium arsenide (p-GaAs) matrix.

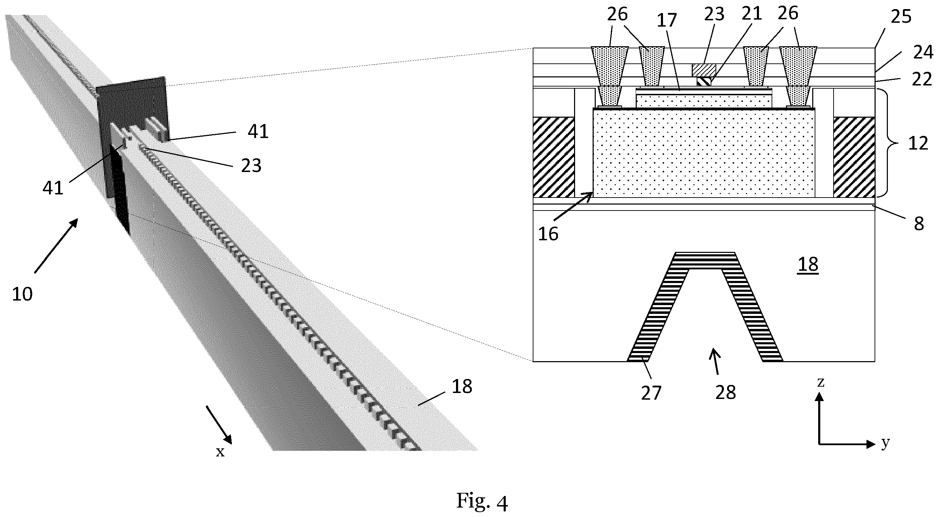

Fig. 4 shows a three dimensional and a cross sectional view of the laser device 10 according to an embodiment.

The three dimensional view shows that the waveguide 23 can propagate along the x-direction perpendicular to y-z-direction of the cross sectional view. For example, light that is generated in the active region 17 of the die 16 can couple into the waveguide 23 by evanescent coupling and propagate along the waveguide 23, e.g. to a photonic circuit.

Furthermore, mirrors 41 can be arranged on the silicon substrate 18 on opposing sides of the die 16 in y-direction, to further confine the light emitted by the active region 18.

## Claims

1. A method for processing a laser device (10), comprising:
- providing a carrier substrate (11);
- forming a grating structure (12) on the carrier substrate (11), wherein the grating structure (12) delimits a cavity (13) on a surface of the carrier substrate (11);
- placing a die (16) in the cavity (13) and bonding the die (16) to the carrier substrate (11), wherein the die (16) comprises an active region (17) from at least one III-V semiconductor material;
- transferring the die (16) from the carrier substrate (11) to a silicon substrate (18) by bonding an exposed side of the die (16) to the silicon substrate (18) and subsequently debonding the carrier (11) substrate from the die (16);
- forming at least one material layer (22, 24, 25) on the die so that the die (16) is fully covered; and
- forming a photonic structure (21) above the die (16).

2. The method of claim 1, wherein the grating structure (12) on the carrier substrate (11) is formed by bonding a structured substrate to the surface of the carrier substrate (11), wherein the structured substrate comprises a through hole.

3. The method of claim 1 or 2, wherein, after placing the die (16) in the cavity (13), the cavity (13) is at least partially filled up by a buffer material (9), in particular an oxide.

4. The method of any one of the preceding claims, wherein the grating structure (12) is transferred together with the die (16) from the carrier substrate (11) to the silicon substrate (18).

5. The method of claim 4, wherein, prior to transferring the die (16) and the grating structure (12) to the silicon substrate (18), the die (16) and the grating structure (12) are grinded and/or polished.

6. The method of any one of the preceding claims, wherein the die (16) comprises a top and a base structure that delimit the active region (17), wherein the top and base structure each comprise at least one III-V or III-N material layer, in particular an indium phosphide (InP), a gallium nitride (GaN), a gallium arsenide (GaAs), an indium arsenide (InAs) or a gallium antimonide (GaSb) layer, and wherein the base structure is bonded to the silicon substrate (18), preferably via at least one bonding layer (8).

7. The method of claim 6, wherein the method further comprises:
- following transferring the die (16) to the silicon substrate (18), structuring the die (16) by a lithographic process to define a dimension of the active region (17) and/or to expose the base structure.

8. The method of claim 7, wherein the method further comprises the steps of:
- forming contact pads (19) on the top structure and the exposed base structure of the die (16); and
- following forming of the at least one material layer (22, 24, 25) above the die (16), electrically contacting the contact pads (19) by etching vias (26) into the at least one material layer and filling said vias (26) with a metal.

9. The method of any one of the preceding claims, wherein the photonic structure (21) is a silicon waveguide.

10. The method of any one of the preceding claims, wherein the photonic structure (21) is formed by depositing a further material layer, in particular a silicon layer, above the die (16) and lithographic structuring said further material layer.

11. The method of any one of the preceding claims, wherein a further photonic structure (23), preferably a silicon nitride waveguide, is formed above the die (16), wherein the further photonic structure (23) is arranged above or next to the photonic structure (21).

12. The method of any one of the preceding claims, wherein the method comprises the further steps of:
- forming a recess (28) at a backside of the silicon substrate (18) below the die (16); and
- coating the backside of the silicon substrate with a metallic material.

13. The method of any one of the preceding claims, wherein the grating structure (12) delimits a plurality of cavities (13) on the surface of the carrier substrate (11), wherein one of a plurality of dies (16) is placed in each respective cavity (13) and bonded to the carrier substrate (11), wherein the plurality of dies (16) are transferred from the carrier substrate (11) to the silicon substrate (18) simultaneously.

14. A laser device (10), obtained by the method of any one of the preceding claims 1-13, , comprising:
a silicon substrate (18);
a die (16) that is arranged in a cavity (30) on the silicon substrate (18), wherein the die (16) comprises an active region (17) from at least one III-V semiconductor material;
wherein the die (16) is bonded to the silicon substrate (18);
wherein the die (16) is fully covered by at least one material layer (22, 24, 25);
wherein the die (16) comprises a top structure (31, 32) and a base structure (33, 34, 35, 36, 37) which comprises a die-substrate (37, said top structure and base structure delimiting the active region (17),
wherein the top structure and the base structure each comprise at least one III-V or III-N material layer,
wherein the base structure is bonded to the silicon substrate (18),
wherein the active region (17) of the die (16) faces away from the silicon substrate (18) and forms a III-V mesa over the die-substrate (37), and
wherein the laser device (10) further comprises at least one photonic structure (21, 23) that is arranged above the die (16) in a direction away from the silicon substrate (18).

15. The laser device (10) of claim 14, wherein the photonic structure (21, 23) is arranged such that light that is generated in the active region (17) couples to the photonic structure (21, 23) by means of evanescent coupling.

## Patentansprüche

1. Verfahren zum Verarbeiten einer Laservorrichtung (10), umfassend:
- Bereitstellen eines Trägersubstrats (11);
- Ausbilden einer Gitterstruktur (12) auf dem Trägersubstrat (11), wobei die Gitterstruktur (12) einen Hohlraum (13) auf einer Oberfläche des Trägersubstrats (11) begrenzt;
- Anordnen eines Dies (16) in dem Hohlraum (13) und Verbinden des Dies (16) mit dem Trägersubstrat (11), wobei der Kavität (16) einen aktiven Bereich (17) aus mindestens einem III-V-Halbleitermaterial umfasst;
- Übertragen des Dies (16) von dem Trägersubstrat (11) auf ein Siliziumsubstrat (18) durch Verbinden einer freiliegenden Seite des Dies (16) mit dem Siliziumsubstrat (18) gefolgt von Ablösen des Trägersubstrats (11) von dem Die (16);
- Ausbilden von mindestens einer Materialschicht (22, 24, 25) auf dem Die, sodass der Die (16) vollständig bedeckt ist; und
- Ausbilden einer photonischen Struktur (21) über dem Die (16) .

2. Verfahren nach Anspruch 1, wobei die Gitterstruktur (12) auf dem Trägersubstrat (11) durch Verbinden eines strukturierten Substrats mit der Oberfläche des Trägersubstrats (11) ausgebildet wird, wobei das strukturierte Substrat ein Durchgangsloch umfasst.

3. Verfahren nach Anspruch 1 oder 2, wobei nach dem Platzieren des Dies (16) in dem Hohlraum (13) der Hohlraum (13) mindestens teilweise mit einem Puffermaterial (9), insbesondere mit einem Oxid, aufgefüllt wird.

4. Verfahren nach einem der vorhergehenden Ansprüche, wobei die Gitterstruktur (12) zusammen mit dem Die (16) von dem Trägersubstrat (11) auf das Siliziumsubstrat (18) übertragen wird.

5. Verfahren nach Anspruch 4, wobei vor dem Übertragen des Dies (16) und der Gitterstruktur (12) auf das Siliziumsubstrat (18) der Die (16) und die Gitterstruktur (12) geschliffen und/oder poliert werden.

6. Verfahren nach einem der vorhergehenden Ansprüche, wobei der Die (16) eine Deckstruktur und eine Basisstruktur umfasst, die den aktiven Bereich (17) begrenzen, wobei die Deckstruktur und die Basisstruktur jeweils mindestens eine Schicht aus III-V- oder III-N-Material umfassen, insbesondere eine Indiumphosphid(InP)-, eine Galliumnitrid(GaN)-, eine Galliumarsenid(GaAs)-, eine Indiumarsenid(InAs)- oder eine Galliumantimonid(GaSb)-Schicht, und wobei die Basisstruktur mit dem Siliziumsubstrat (18) verbunden ist, vorzugsweise über mindestens eine Verbindungsschicht (8).

7. Verfahren nach Anspruch 6, wobei das Verfahren ferner umfasst:
- nach dem Übertragen des Dies (16) auf das Siliziumsubstrat (18), Strukturieren des Dies (16) durch einen lithographischen Prozess, um eine Abmessung des aktiven Bereichs (17) festzulegen und/oder um die Basisstruktur freizulegen.

8. Verfahren nach Anspruch 7, wobei das Verfahren ferner die Schritte umfasst:
- Ausbilden von Kontaktpads (19) auf der Deckstruktur und der freiliegenden Basisstruktur des Dies (16); und
- nach dem Ausbilden der mindestens einen Materialschicht (22, 24, 25) über dem Die (16), elektrisches Kontaktieren der Kontaktpads (19) durch Ätzen von Durchkontaktierungen (26) in die mindestens eine Materialschicht und Füllen der Durchkontaktierungen (26) mit einem Metall.

9. Verfahren nach einem der vorhergehenden Ansprüche, wobei die photonische Struktur (21) ein Silizium-Wellenleiter ist.

10. Verfahren nach einem der vorhergehenden Ansprüche, wobei die photonische Struktur (21) durch Abscheiden einer weiteren Materialschicht, insbesondere einer Siliziumschicht, über dem Die (16) und durch lithografisches Strukturieren dieser weiteren Materialschicht ausgebildet wird.

11. Verfahren nach einem der vorhergehenden Ansprüche, wobei eine weitere photonische Struktur (23), vorzugsweise ein Siliziumnitrid-Wellenleiter, über dem Die (16) ausgebildet wird,
wobei die weitere photonische Struktur (23) über oder neben der photonischen Struktur (21) angeordnet ist.

12. Verfahren nach einem der vorhergehenden Ansprüche, wobei das Verfahren die weiteren Schritte umfasst:
- Ausbilden einer Ausnehmung (28) auf einer Rückseite des Siliziumsubstrats (18) unterhalb des Dies (16); und
- Beschichten der Rückseite des Siliziumsubstrats mit einem metallischen Material.

13. Verfahren nach einem der vorhergehenden Ansprüche, wobei die Gitterstruktur (12) eine Vielzahl von Hohlräumen (13) auf der Oberfläche des Trägersubstrats (11) abgrenzt, wobei in jedem jeweiligen Hohlraum (13) einer einer Vielzahl von Dies (16) platziert und mit dem Trägersubstrat (11) verbunden wird, wobei die Vielzahl von Dies (16) gleichzeitig vom Trägersubstrat (11) auf das Siliziumsubstrat (18) übertragen wird.

14. Laservorrichtung (10), erhalten durch das Verfahren nach einem der vorhergehenden Ansprüche 1-13, umfassend:
ein Siliziumsubstrat (18);
einen Die (16), angeordnet in einem Hohlraum (30) auf dem Siliziumsubstrat (18), wobei der Die (16) einen aktiven Bereich (17) aus mindestens einem III-V-Halbleitermaterial umfasst;
wobei der Die (16) mit dem Siliziumsubstrat (18) verbunden ist;
wobei der Die (16) vollständig von mindestens einer Materialschicht (22, 24, 25) bedeckt ist;
wobei der Die (16) eine Deckstruktur (31, 32) und eine Basisstruktur (33, 34, 35, 36, 37) umfasst, die ein Die-Substrat (37) umfasst, wobei die Deckstruktur und die Basisstruktur den aktiven Bereich (17) begrenzen,
wobei die Deckstruktur und die Basisstruktur jeweils mindestens eine III-V- oder III-N-Materialschicht umfassen,
wobei der Basisstruktur mit dem Siliziumsubstrat (18) verbunden ist,
wobei der aktive Bereich (17) des Dies (16) von dem Siliziumsubstrat (18) weg weist und eine III-V-Mesa über dem Die-Substrat (37) ausbildet, und
wobei die Laservorrichtung (10) ferner mindestens eine photonische Struktur (21, 23) umfasst, die über dem Die (16) in einer von dem Siliziumsubstrat (18) weg weisenden Richtung angeordnet ist.

15. Laservorrichtung (10) nach Anspruch 14, wobei die photonische Struktur (21, 23) so angeordnet ist, dass Licht, das in der aktiven Region (17) erzeugt wird, mittels evaneszenter Kopplung an die photonische Struktur (21, 23) gekoppelt wird.

## Revendications

1. Procédé de traitement d'un dispositif laser (10), comprenant :
- l'obtention d'un substrat de support (11) ;
- la formation d'une structure de réseau (12) sur le substrat de support (11), la structure de réseau (12) délimitant une cavité (13) sur une surface du substrat de support (11) ;
- la mise en place d'une puce (16) dans la cavité (13) et l'assemblage de la puce (16) au substrat de support (11), la puce (16) comprenant une région active (17) élaborée à partir d'au moins un matériau semi-conducteur III-V ;
- le transfert de la puce (16) du substrat de support (11) à un substrat de silicium (18) par assemblage d'une face exposée de la puce (16) au substrat de silicium (18) et désassemblage consécutif du substrat de support (11) de la puce (16) ;
- la formation d'au moins une couche de matériau (22, 24, 25) sur la puce de telle sorte que la puce (16) soit totalement recouverte ; et
- la formation d'une structure photonique (21) au-dessus de la puce (16).

2. Procédé selon la revendication 1, dans lequel la structure de réseau (12) sur le substrat de support (11) est formée par assemblage d'un substrat structuré à la surface du substrat de support (11), le substrat structuré comprenant un trou traversant.

3. Procédé selon la revendication 1 ou 2, dans lequel, après la mise en place de la puce (16) dans la cavité (13), la cavité (13) est au moins partiellement remplie avec un matériau tampon (9), en particulier un oxyde.

4. Procédé selon l'une quelconque des revendications précédentes, dans lequel la structure de réseau (12) est transférée conjointement avec la puce (16) du substrat de support (11) au substrat de silicium (18).

5. Procédé selon la revendication 4, dans lequel, avant le transfert de la puce (16) et de la structure de réseau (12) au substrat de silicium (18), la puce (16) et la structure de réseau (12) sont rectifiées et/ou polies.

6. Procédé selon l'une quelconque des revendications précédentes, dans lequel la puce (16) comprend une structure supérieure et une structure de base qui délimitent la région active (17), dans lequel la structure supérieure et la structure de base comprennent chacune au moins une couche de matériau III-V ou III-N, en particulier une couche de phosphure d'indium (InP), de nitrure de gallium (GaN), d'arséniure de gallium (GaAs), d'arséniure d'indium (InAs) ou d'antimoniure de gallium (GaSb), et dans lequel la structure de base est assemblée au substrat de silicium (18), de préférence par le biais d'au moins une couche d'assemblage (8).

7. Procédé selon la revendication 6, le procédé comprenant en outre :
- après le transfert de la puce (16) au substrat de silicium (18), la structuration de la puce (16) par un processus lithographique pour définir une dimension de la région active (17) et/ou pour exposer la structure de base.

8. Procédé selon la revendication 7, le procédé comprenant en outre les étapes suivantes :
- formation de plots de contact (19) sur la structure supérieure et la structure de base exposée de la puce (16) ; et
- après la formation de l'au moins une couche de matériau (22, 24, 25) au-dessus de la puce (16), mise en contact électrique des plots de contact (19) par gravure de trous d'interconnexion (26) à l'intérieur de l'au moins une couche de matériau et remplissage desdits trous d'interconnexion (26) avec un métal.

9. Procédé selon l'une quelconque des revendications précédentes, dans lequel la structure photonique (21) est un guide d'ondes en silicium.

10. Procédé selon l'une quelconque des revendications précédentes, dans lequel la structure photonique (21) est formée par dépôt d'une couche supplémentaire de matériau, en particulier d'une couche de silicium, au-dessus de la puce (16) et structuration lithographique de ladite couche supplémentaire de matériau.

11. Procédé selon l'une quelconque des revendications précédentes, dans lequel une structure photonique supplémentaire (23), de préférence un guide d'ondes en nitrure de silicium, est formée au-dessus de la puce (16), la structure photonique supplémentaire (23) étant disposée au-dessus ou à côté de la structure photonique (21) .

12. Procédé selon l'une quelconque des revendications précédentes, le procédé comprenant les étapes supplémentaires suivantes :
- formation d'une encoche (28) sur une face arrière du substrat de silicium (18) en dessous de la puce (16) ; et
- revêtement de la face arrière du substrat de silicium avec un matériau métallique.

13. Procédé selon l'une quelconque des revendications précédentes, dans lequel la structure de réseau (12) délimite une pluralité de cavités (13) sur la surface du substrat de support (11), dans lequel une puce d'une pluralité de puces (16) est placée dans chaque cavité respective (13) et assemblée au substrat de support (11), dans lequel la pluralité de puces (16) sont transférées simultanément du substrat de support (11) au substrat de silicium (18).

14. Dispositif laser (10), obtenu par le procédé selon l'une quelconque des revendications 1 à 13 précédentes, comprenant :
un substrat de silicium (18) ;
une puce (16) qui est disposée dans une cavité (30) sur le substrat de silicium (18), la puce (16) comprenant une région active (17) élaborée à partir d'au moins un matériau semi-conducteur III-V ;
dans lequel la puce (16) est assemblée au substrat de silicium (18),
dans lequel la puce (16) est totalement recouverte par au moins une couche de matériau (22, 24, 25),
dans lequel la puce (16) comprend une structure supérieure (31, 32) et une structure de base (33, 34, 35, 36, 37) qui comprend un substrat de puce (37), lesdites structure supérieure et structure de base délimitant la région active (17),
dans lequel la structure supérieure et la structure de base comprennent chacune au moins une couche de matériau III-V ou III-N,
dans lequel la structure de base est assemblée au substrat de silicium (18),
dans lequel la région active (17) de la puce (16) tourne le dos au substrat de silicium (18) et forme une mesa III-V au-dessus du substrat de puce (37), et
dans lequel le dispositif laser (10) comprend en outre au moins une structure photonique (21, 23) qui est disposée au-dessus de la puce (16) dans une direction s'éloignant du substrat de silicium (18).

15. Dispositif laser (10) selon la revendication 14, dans lequel la structure photonique (21, 23) est disposée de telle sorte que la lumière qui est générée dans la région active (17) se couple à la structure photonique (21, 23) au moyen d'un couplage évanescent.
